# EUROPÄISCHE PATENTSCHRIFT

(11) **EP 2 327 090 B1**
(45) Veröffentlichungstag und Bekanntmachung des Hinweises auf die Patenterteilung: **04.11.2020**
(21) Anmeldenummer: 09782767.9
(22) Anmeldetag: 08.09.2009
(51) Int. Cl.: H01L 21/683, H01L 21/67

(54) **DREHBARES, BEHEIZBARES PLATZIERWERKZEUG UND CHIPMONTAGEAUTOMAT MIT EINEM SOLCHEN PLATZIERWERKZEUG**
ROTATABLE, HEATABLE PLACEMENT TOOL AND CHIP MOUNTING SYSTEM COMPRISING SUCH A PLACEMENT TOOL
OUTIL DE POSITIONNEMENT POUVANT ÊTRE CHAUFFÉ ET TOURNÉ, ET MICROSOUDEUSE DE PUCES ÉQUIPÉE D'UN TEL OUTIL DE POSITIONNEMENT

(30) Priorität: 09.09.2008 US 95417 P
(43) Veröffentlichungstag der Anmeldung: 01.06.2011
(73) Patentinhaber: Kulicke & Soffa (Switzerland) Management GmbH, 8572 Berg TG (CH)
(72) Erfinder: TRINKS, Joachim, CH-9230 Flawil (CH)
(74) Vertreter: Körner, Thomas Ottmar
(86) Internationale Anmeldenummer: PCT/EP2009/061634
(87) Internationale Veröffentlichungsnummer: WO 2010/029075

(56) Entgegenhaltungen:
- JP-A- 2003 174 042
- US-A1- 2002 108 707
- US-A1- 2003 197 048
- US-A1- 2006 076 388

## Beschreibung

### Einleitung

Die vorliegende Erfindung betrifft das Gebiet der Halbleitermontage. Sie bezieht sich auf ein drehbares, beheizbares Platzierwerkzeug nach dem Oberbegriffen des unabhängigen Patentanspruchs und auf einen Chipmontageautomat mit einem solchen Platzierwerkezeug.

### Stand der Technik

Bei der Montage von Halbleiterbauelementen (engl. "dies") auf ein Substrat mittels eines Chipmontageautomaten (engl. "die bonder") wird im Allgemeinen eine Verbindungsschicht zwischen einzelnen Halbleiterbauelementen und dem Substrat vorgesehen, welche einen Klebstoff und/oder ein Lot umfasst. Diese Verbindungsschicht kann entweder in flüssiger Form - im Allgemeinen auf das Substrat - aufgebracht werden (engl. "dispense"), sie kann aber auch in Form einer Folie (engl. "tape") vorgesehen werden. Dabei kann die Folie auf dem Substrat aufgebracht werden, bevor das Halbleiterbauelement platziert wird, sie kann aber auch bereits auf einer Rückseite eines Halbleiterwafers, aus welchem die Halbleiterbauelemente mittels Schneiden (engl. "dicing") gewonnen werden, aufgebracht sein. In letzerem Fall spricht man von Waferrückseitenlaminierung (engl.: "wafer backside lamination", kurz WBL; oder "film over wire", kurz FOW).

Um eine möglichst stabile und verlässliche Verbindung zwischen Halbleiterbauelement und Substrat zu erreichen, muss die Verbindungsschicht häufig erwärmt werden. Zu diesem Zweck kann beispielsweise das Halbleiterbauelement und/oder das Substrat erwärmt werden. Die US-Offenlegungsschrift 2005/0081986 A1, welche hiermit in vollem Umfang mittels Verweisung eingefügt wird, beschreibt einen geheizten Montagekopf (engl "bond head"), in welchen ein Halteelement (engl, "die collet") für die Halbleiterbauelemente eingesetzt ist. Ein ähnlicher Montagekopf ist in der US-Offenlegungsschrift 2006/0076388 beschrieben.

Nachteilig dabei ist, dass ein Heizelement im Montagekopf relativ weit von einer Auflagefläche des Halteelements entfernt ist, welche mit dem Halbleiterbauelement in Berührung kommt. Insbesondere für den Fall, dass eine Temperatur der Auflagefläche zeitlich variierbar sein muss, werden aufgrund einer relativ grossen Wärmekapazität des gesamten Halteelements Wartezeiten notwendig, welche einen erreichbaren Durchsatz an Halbleiterbauelementen verringern. Dies ist vor allem dann der Fall, wenn der Montagekopf die zu montierenden Halbleiterbauelemente auch von einer Auflagevorrichtung für den Halbleiterwafer aufnimmt, weil eine Erwärmung der Halbleiterbauelemente auf der Auflagevorrichtung besonders bei rückseitig laminierten Halbleiterwafern unerwünscht ist.

Auch für den Fall, dass die zu montierenden Halbleiterbauelemente nicht vom Montagekopf von der Auflagevorrichtung für den Halbleiterwafer aufgenommen werden, sondern von einem eigens für diesen Zweck vorgesehenen Primärwerkzeug, wird unter Umständen eine zeitliche Variation der Temperatur der Auflagefläche gewünscht, um ein Verkleben des Halbleiterbauelements mit der Auflagefläche zu vermeiden. Gleiches gilt, wenn der Montagekopf die Halbleiterbauelemente von einem Schwenkwerkzeug oder von einer Zwischenstation aufnimmt. Entsprechende Chipmontageautomaten sind in der WO 2007/118511 A1 bzw. in der WO 2007/033701 A1 beschrieben.

Nachteilig ist ferner, dass weder der Montagekopf noch das Halteelement um eine Achse senkrecht zum Wafer bzw. Substrat drehbar sind. Somit können weder Winkelkorrekturen vorgenommen werden, um geringfügige Verdrehungen von Wafer und Substrat zu auszugleichen, noch können unterschiedliche Halbleiterbauelemente in verschiedener Orientierung auf das Substrat aufgesetzt werden.

### Darstellung der Erfindung

Es ist daher Aufgabe der Erfindung, ein Chipmontageautomaten und ein Platzierwerkzeug für einen solchen anzugeben, welches die oben genannten Nachteile nicht aufweist.

Diese Aufgabe wird gelöst durch ein Platzierwerkzeug welches in Richtung einer z-Achse senkrecht zu einem Substrat bewegbar ist, umfassend:
ein Halteelement für ein Halbleiterbauelement, wobei das Halteelement wechselbar ausgeführt ist und wobei das Halteelement ein
   Heizelement umfasst,
eine Aufnahme für das Halteelement, welche drehbar um die z-Achse am Platzierwerkzeug gelagert ist und einen Isolationskörper aus wärmeisolierendem Material umfasst,
einen Antrieb für die Aufnahme, mittels welchem die Aufnahme um die z-Achse gedreht werden kann
eine Zuführung für ein Kühlfluid, mittels welchem die Aufnahme für das Halteelement gekühlt werden kann;
sowie einen Chipmontageautomaten mit einem derartigen Platzierwerkzeug.

Diese und weitere Aufgaben, Vorteile und Merkmale der Erfindung werden aus der nachfolgenden detaillierten Beschreibung bevorzugter Ausführungsbeispiele in Verbindung mit den Zeichnungen offensichtlich.

### Kurze Beschreibung der Zeichnungen

Es zeigen:
Fig. 1 eine perspektivische Darstellung eines erfindungsgemässen drehbaren, beheizbaren Platzierwerkzeugs,
Fig. 2 eine weitere perspektivische Darstellung des drehbaren, beheizbaren Platzierwerkzeugs aus Fig. 1,
Fig. 3 einen Querschnitt durch ein drehbares, beheizbares Platzierwerkzeug gemäss Fig. 1 und Fig. 2.

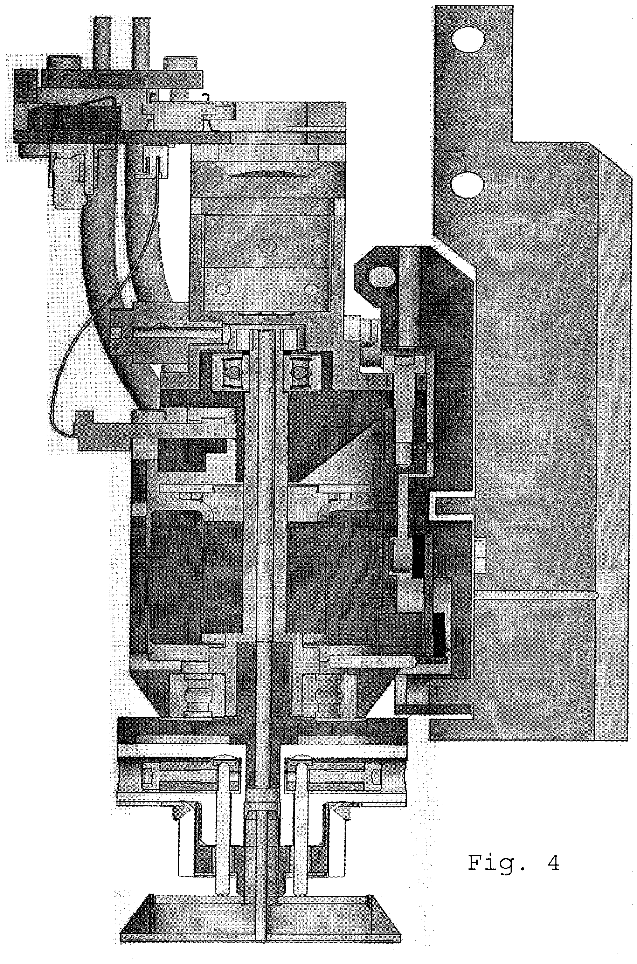

Fig. 4 eine farbige Darstellung der Fig. 3

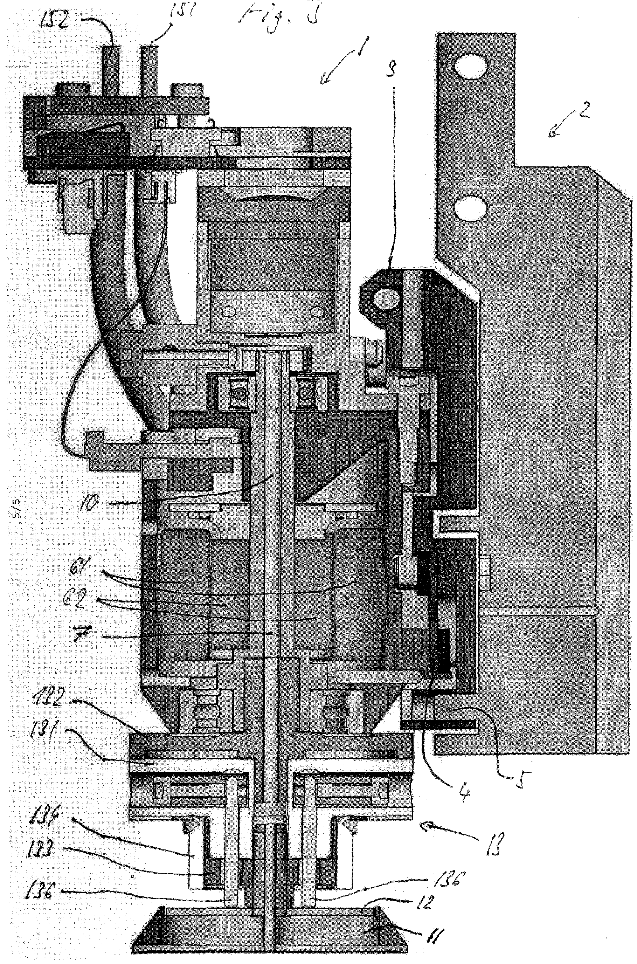

Fig. 5 die Darstellung aus Fig 4 mit Bezugszeichen.

### Wege zur Ausführung der Erfindung

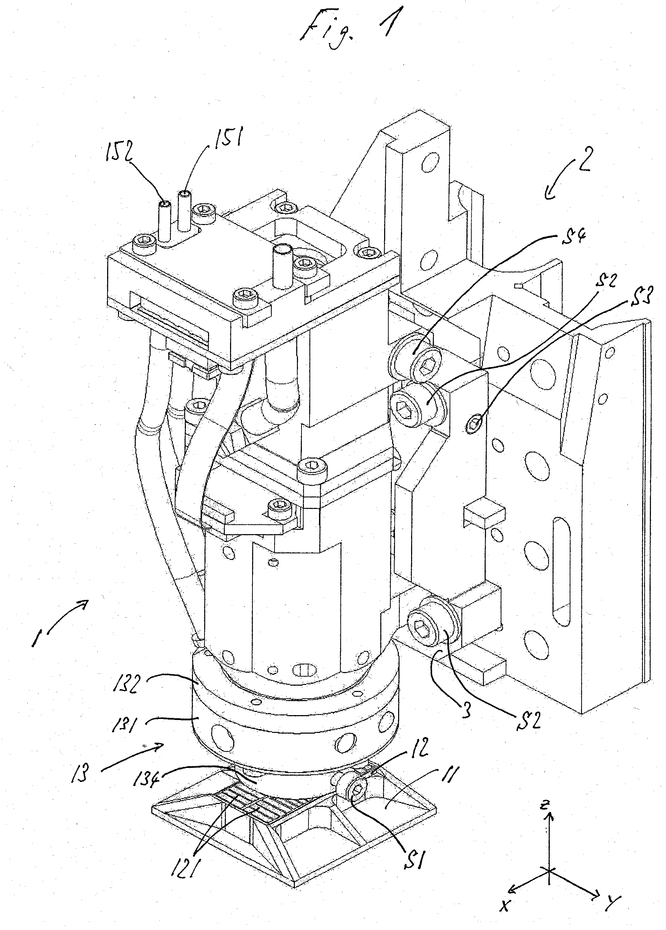

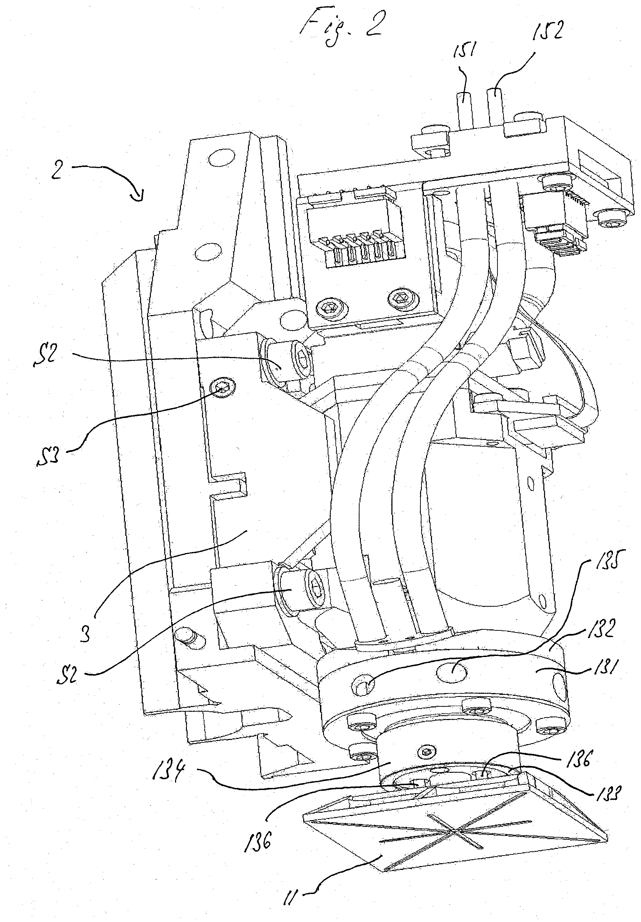

Fig. 1 und Fig. 2 zeigen perspektivische Darstellungen eines drehbaren, beheizbaren Platzierwerkzeugs 1 gemäss der vorliegenden Erfindung aus unterschiedlichen Blickwinkeln. Das Platzierwerkzeug 1 kann mittels eines Schlittens 2, an welchem dieses befestigt ist, in einer z-Richtung verfahren werden. Das Platzierwerkzeug 1 umfasst ein Halteelement 11 für ein Halbleiterbauelement, wobei das Halteelement ein Heizelement 12 aus Al₂O₃ umfasst, auf welchem mindestens ein Schichtwiderstand 121 aufgebracht ist.

Das Halteelement 11 ist in eine Aufnahme 13 eingesetzt, welche um die z-Richtung drehbar ist. Die Aufnahme 13 umfasst einen Isolationskörper 131 aus Keramik, welcher an einem ersten metallischen Halter 132 festgeschraubt ist. Über eine Zuführung 151 kann der Aufnahme 13 zum Zwecke einer Kühlung Luft zugeführt werden, so dass diese innerhalb der Aufnahme 13 zirkulieren und über eine Ableitung 152 wieder ausgeleitet werden kann. An einer dem Halteelement 11 zugewandten Seite der Aufnahme 13 ist ein zweiter metallischer Halter 133 vorgesehen, in welchem sich ein Thermosensor befindet, mittels welchem die Temperatur des Halteelements 11 gemessen oder geschätzt werden kann. Eine Anordnung des Thermosensors im zweiten metallischen Halter 133 erlaubt einen einfachen Wechsel des Halteelements 11. Im zweiten metallischen Halter 133 ist ferner ein Schraubgewinde für eine Fixierung des Halteelements 11 in der Aufnahme 13 mittels einer Schraube S1 vorgesehen. Der zweite metallische Halter 133 ist wiederum von einer Keramikhülse 134 umgeben, um Wärmeverluste aufgrund schneller Bewegungen in x- oder γ-Richtung zu vermeiden, die das Platzierwerkzeug in einem Betrieb ausführt. Öffnungen 135 im Isolationskörper 131 dienen einer Durchführung von Anschlusskabeln für den Thermosensor und das Heizelement 12, welches über gefederte vergoldete Kontaktstifte 136 mit Strom versorgt wird.

In einer bevorzugten Ausgestaltung der Erfindung befindet sich in oder an einer Ableitung ein Flusssensor, welcher eine Menge ausgeleiteter Luft überwacht. Ferner ist ein Schutzschaltkreis vorgesehen, welcher eine Heizleistung des Heizelements 12 reduziert oder unterbricht, wenn die Menge ausgeleiteter Luft einen bestimmten Grenzwert unterschreitet. Auf diese Weise können im Falle eines Lecks in Versorgungsleitungen oder an anderer Stelle Beschädigungen vermieden werden.

Das Platzierwerkzeug 1 ist am Schlitten 2 so gelagert, dass es zu Kalibrationszwecken um die x- und γ-Richtung drehbar ist.

Um das Platzierwerkzeug 1 um die x-Richtung zu verdrehen, müssen Klemmschrauben S2 gelockert werden. Eine Positionskorrektur kann dann mittels Stellschrauben S3 vorgenommen werden. Anschliessend müssen die Klemmschrauben S2 wieder angezogen werden. Die Verdrehung in x-Richtung wird dadurch ermöglicht, dass das Platzierwerkzeug 1 mittels einem Justierelement 3 auf einem zylindrischen Vorsprung 5 gelagert ist, welcher am Schlitten 2 vorgesehen ist.

Um das Platzierwerkzeug 1 um die *γ*-Richtung zu verdrehen, muss eine Klemmschraube S4 gelockert werden. Eine Positionskorrektur kann dann mittels einer weiteren Stellschraube vorgenommen werden. Dabei ist das Platzierwerkzeug 1 mittels einer Blattfeder 4 gegen das Justierelement 3 vorgespannt und an diesem drehbar um die *γ-*Richtung gelagert.

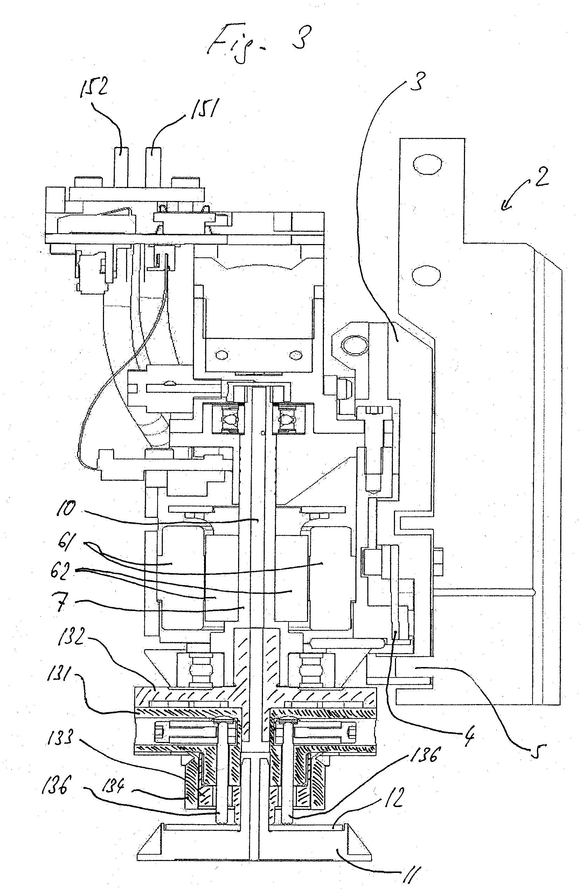

Fig. 3 zeigt einen Querschnitt durch das drehbare, beheizbare Platzierwerkzeug gemäss Fig. 1 und Fig. 2. Der erste metallische Halter 132 ist mit einer Hohlachse 7 verbunden, welche wiederum mit einem Rotor 62 eines Elektromotors verbunden ist, welcher unter Mitwirkung eines Stators 61 in Rotationsbewegungen um die z-Richtung vollführen kann. Ein Vakuumkanal 10 dient dazu, einen Unterdruck an Vakuumkanäle anzulegen, welche in einer Unterseite des Halteelements 11 vorgesehen sind. Auf diese Weise kann ein Halbleiterbauelement angesaugt werden und auf ein unterhalb des Platzierwerkzeug 1 befindliches Substrat abgelegt werden.

Um den Unterdruck an das Halteelement 11 weiterzuleiten, sind im ersten metallischen Halter 132 und im Isolationskörper 131 Durchführungen vorgesehen.

Auch wenn die Erfindung vorstehend mit Bezug auf spezifische Ausführungsformen beschrieben und veranschaulicht ist, ist diese nicht auf diese Ausführungsformen beschränkt. Die Erfindung ist vielmehr durch die Ansprüche definiert.

## Patentansprüche

1. Platzierwerkzeug (1), welches in Richtung einer z-Achse senkrecht zu einem Substrat bewegbar ist, umfassend:
a) eine Aufnahme (13) für ein Halteelement für ein Halbleiterbauelement, welche drehbar um die z-Achse am Platzierwerkzeug gelagert ist und einen Isolationskörper aus wärmeisolierendem Material umfasst,
b) einen Antrieb für die Aufnahme, mittels welchem die Aufnahme um die z-Achse gedreht werden kann,
c) eine Zuführung (151) für ein Kühlfluid, mittels welchem die Aufnahme für das Halteelement gekühlt werden kann, **dadurch gekennzeichnet, dass**
d) das Halteelement wechselbar ausgeführt ist, wobei das Halteelement ein Heizelement umfasst.

2. Platzierwerkzeug (1) nach Anspruch 1, welches mit Luft als Kühlfluid gekühlt wird.

3. Platzierwerkzeug (1) nach einem der vorangehenden Ansprüche, **dadurch gekennzeichnet, dass** Aufnahme einen Isolationskörper zur thermischen Isolation des Halteelement vom Platzierwerkzeug umfasst.

4. Platzierwerkzeug (1) nach Anspruch 3, **dadurch gekennzeichnet, dass** der Isolationskörper aus Keramik besteht.

5. Platzierwerkzeug (1) nach einem der vorangehenden Ansprüche, **dadurch gekennzeichnet, dass** der Isolationskörper an einem ersten metallischen Halter befestigt ist, welcher um die z-Achse gedreht werden kann.

6. Chipmontageautomat mit einem Platzierwerkzeug (1) nach einem der vorangehenden Ansprüche.

## Claims

1. A placement tool (1) movable in the direction of a z-axis perpendicular to a substrate comprising:
a) a receptacle (13) for a holding element for a semiconductor device, which is mounted rotatably about the z-axis on the placement tool and comprises an insulating body made of heat-insulating material,
b) a drive for the mount by means of which the mount can be rotated about the z-axis,
c) a supply (151) for a cooling fluid, by means of which the receptacle for the holding element can be cooled, **characterized in that**
d) the holding element (11) is designed to be exchangeable, said holding member comprising a heating element.

2. The placement tool (1) according to claim 1, which is cooled with air as cooling fluid.

3. The placement tool (1) according to one of the preceding claims, **characterized in that** the receptacle comprises an insulating body for thermal insulation of the holding element from the placement tool.

4. The placement tool (1) according to claim 3, **characterized in that** the insulating body consists of ceramic.

5. The placement tool (1) according to one of the preceding claims, **characterized in that** the insulating body is attached to a first metallic holder which may be rotated about the z-axis.

6. Die bonder with a placement tool (1) according to one of the preceding claims.

## Revendications

1. Un outil de placement (1) mobile dans la direction d'un axe z perpendiculaire à un substrat, comprenant :
a) un élément de maintien (11) échangeable pour un composant semi-conducteur, l'élément de maintien comprenant un élément chauffant,
b) un réceptacle (13) pour l'élément de maintien, qui est monté sur l'outil de placement de manière à pouvoir tourner autour de l'axe z et qui comprend un corps isolant en matériau calorifuge,
c) un entraînement pour le support, au moyen duquel le support peut être tourné autour de l'axe z,
d) une alimentation (151) en fluide de refroidissement, grâce à laquelle le réceptacle de l'élément de retenue peut être refroidi.

2. Outil de placement (1) selon la revendication 1, qui est refroidi avec de l'air comme fluide de refroidissement.

3. Outil de placement (1) selon l'une des revendications précédentes, **caractérisé en ce que** le réceptacle comprend un corps isolant pour l'isolation thermique de l'élément de maintien par rapport à l'outil de placement.

4. Outil de placement (1) selon la revendication 3, **caractérisé en ce que** le corps isolant est constitué de céramique.

5. Outil de placement (1) selon l'une des revendications précédentes, **caractérisé en ce que** le corps isolant est fixé à un premier support métallique qui peut être tourné autour de l'axe z.

6. Microsoudeuse de puces équipée d'un outil de placement (1) selon l'une des revendications précédentes.
